(19) Europäisches Patentamt
European Patent Office
Office européen des brevets

(11) EP 2 720 054 A1

(12) EUROPEAN PATENT APPLICATION
published in accordance with Art. 153(4) EPC

(43) Date of publication:
16.04.2014 Bulletin 2014/16

(51) Int Cl.:
G01R 31/36 (2006.01)

(21) Application number: 11867210.4

(22) Date of filing: 10.06.2011

(86) International application number:
PCT/JP2011/063356

(87) International publication number:
WO 2012/169061 (13.12.2012 Gazette 2012/50)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

• KAWAHARA, Youhei
Chiyoda-ku, Tokyo 100-8280 (JP)
• NAKAO, Ryouhei
Chiyoda-ku, Tokyo 100-8280 (JP)

(71) Applicant: HITACHI VEHICLE ENERGY, LTD.
312-8505 Ibaraki (JP)

(72) Inventors:
• OHKAWA, Keiichiro
Ibaraki 312-8505 (JP)

(74) Representative: Beetz & Partner
Patentanwälte
Steinsdorfstraße 10
80538 München (DE)

(54) **BATTERY CONTROL DEVICE AND BATTERY SYSTEM**

(57) A battery control apparatus which can calculate a state of charge of a battery with high accuracy is provided. The battery control apparatus of the invention determines whether or not an open circuit voltage of a battery cell is within a high sensitivity range in which the open voltage of the battery cell changes by a specified amount or more with respect to a change in the state of charge of the battery cell, and if within the high sensitivity range, calculates the state of charge by using a previously held correspondence relation table between the state of charge of the battery and the open voltage, and if not within the high sensitivity range, uses a previous state of charge calculation result stored in a storage part.

[FIG. 7]

**Description**

Technical Field

The present invention relates to a technique to calculate a state of charge of a battery.

Background Art

A vehicle running by using electricity as driving force is mounted with a storage battery such as a lead-acid battery, a nickel hydrogen battery or a lithium ion battery. The electric power required when a hybrid vehicle or an electric vehicle runs is supplied by the storage battery. In order to control the operation of the storage battery, it is required that especially, the state of charge of the battery is calculated, and charge and discharge current and the like are suitably controlled according to the value.

PTL 1 mentioned below discloses a technique to calculate a state of charge of a battery in view of the influence of polarization voltage.

Citation List

Patent Literature

PTL 1: JP-A-2008-64496

Summary of Invention

Technical Problem

A correspondence relation between an open circuit voltage (OCV) of a battery and a state of charge (SOC) is not necessarily a proportional relation. There is a case where the open circuit voltage is not largely changed with respect to the change of the state of charge according to the characteristic of the battery. In this case, according to the method of calculating the state of charge from the correspondence relation between the open circuit voltage and the state of charge, SOC calculation error generated by voltage detection error becomes large.

In this point, according to the technique disclosed in PTL 1, since the change of the open circuit voltage with respect to the change of the state of charge is not considered, there is a possibility that sufficient calculation accuracy can not be obtained according to a position where the calculation of the state of charge is started.

The invention is made in order to solve the problem as described above, and has an object to provide a battery control apparatus which can calculate a state of charge of a battery with high accuracy.

Solution to Problem

A battery control apparatus of the invention determines whether or not an open circuit voltage (or SOC) of a battery is within a high sensitivity range in which the open circuit voltage of the battery changes by a specified amount or more with respect to a change in a state of charge of the battery, and if within the high sensitivity range, calculates the state of charge by using a previously held correspondence relation table, and if not within the high sensitivity range, uses a previous SOC calculation final value.

Advantageous Effects of Invention

According to the battery control apparatus of the invention, if it is expected that the accuracy of calculating the state of charge by using the table is sufficiently high, the table is used, and if not so, the previous SOC calculation final value is used. Accordingly, the SOC can be calculated with higher accuracy according to the battery state when the SOC calculation is started.

Brief Description of Drawings

[FIG. 1] FIG. 1 is a view showing a battery system 100 of embodiment 1 and its peripheral circuit.
[FIG. 2] FIG. 2 is a view showing a circuit structure of a battery cell control part 121.

[FIG. 3] FIG. 3 is a view showing an example of an SOC table 181 stored in a storage part 180.

[FIG. 4] FIG. 4 is a view represented in control block and showing the whole procedure in which a battery pack control part 150 calculates an SOC of a battery cell 111.

[FIG. 5] FIG. 5 is a view showing a detailed structure of a start time SOC calculation part 151 and an SOC change amount calculation part 152.

[FIG. 6] FIG. 6 is a view showing a detailed structure of an SOCv calculation part 1511 and an SOCold calculation part 1512.

[FIG. 7] FIG. 7 is a flowchart for explaining an operation procedure in which the battery system 100 calculates an SOC of each battery cell 111.

[FIG. 8] FIG. 8 is a view showing a battery system of embodiment 2 and its peripheral circuit structure.

[FIG. 9] FIG. 9 is a view represented in control block and showing the whole procedure in which a battery pack control part 150 calculates an SOC of a battery cell 111 in embodiment 2.

[FIG. 10] FIG. 10 is a view showing a detailed structure of an SOCv calculation part 1511 and an SOCold calculation part 1512 in embodiment 2.

[FIG. 11] FIG. 11 is a flowchart for explaining an operation procedure in which the battery system 100 calculates an SOC of each battery cell 111 in embodiment 2.

[FIG. 12] FIG. 12 is a flowchart for explaining an operation procedure in which a battery system 100 calculates an SOC of each battery cell 111 in embodiment 3.

Description of Embodiments

Hereinafter, embodiments of the invention will be described with reference to the drawings. In the following embodiments, a case where the invention is applied to a battery system constituting a power source of a plug-in hybrid electric vehicle (PHEV) will be exemplified.

Besides, in the following embodiments, a case where a lithium ion battery is adopted will be exemplified. However, in addition, a nickel hydrogen battery, a lead-acid battery, an electric double layer capacitor or a hybrid capacitor can also be used. Incidentally, in the following embodiments, although battery cells are connected in series to constitute a battery pack, the battery pack may be constructed by connecting parallel-connected battery cells in series, or the battery pack may be constructed by connecting series-connected battery cells in parallel.

<Embodiment 1: System Structure>

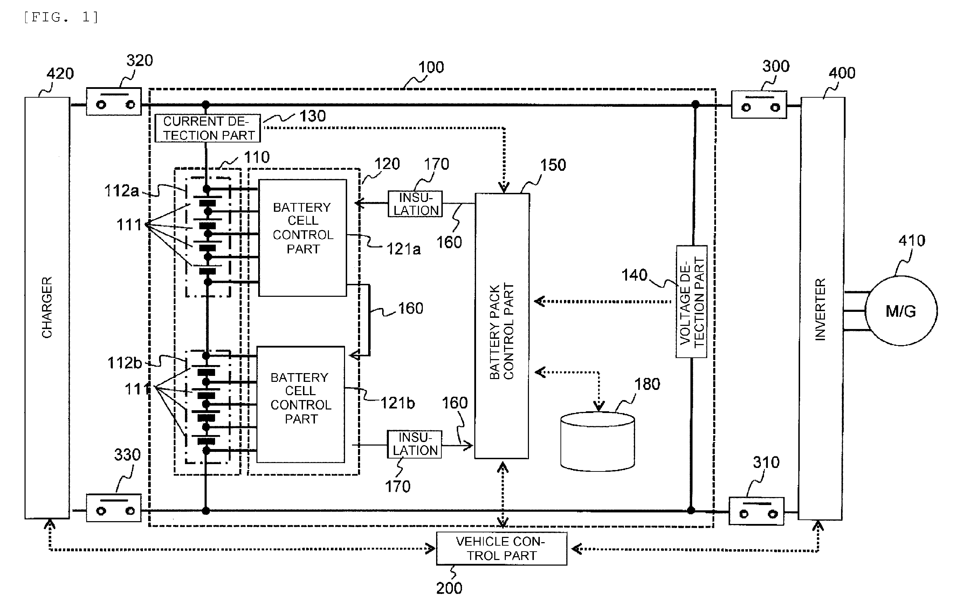

FIG. 1 is a view showing a battery system 100 of embodiment 1 of the invention and its peripheral circuit structure. The battery system 100 is connected to an inverter 400 through relays 300 and 310, and is connected to a charger 420 through relays 320 and 330. The battery system 100 includes a battery pack 110, a battery cell management part 120, a current detection part 130, a voltage detection part 140, a battery pack control part 150 and a storage part 180.

The battery pack 110 is constructed of plural battery cells 111. The battery cell management part 120 monitors states of the battery cells 111. The current detection part 130 detects a current flowing through the battery system 100. The voltage detection part 140 detects the total voltage of the battery pack 110. The battery pack control part 150 controls the battery pack 110.

The battery pack control part 150 receives the battery voltage of the battery cell 111 and temperature transmitted by the battery cell management part 120, the current value flowing through the battery system 100 and transmitted by the current detection part 130, and the total voltage value of the battery pack 110 transmitted by the voltage detection part 140. The battery pack control part 150 detects the state of the battery pack 110 based on the received information, and controls the operation. The processing result of the battery pack control part 150 is transmitted to the battery cell management part 120 and a vehicle control part 200.

The battery pack 110 is constructed such that the plural battery cells 111 capable of storing and discharging electric energy (charging and discharging of DC current) are electrically connected in series. The battery cells 111 constituting the battery pack 110 are grouped by a specified number of units for execution of state management and control. The grouped battery cells 111 are electrically connected in series, and constitute battery cell groups 112a and 112b. The number of the battery cells 111 constituting the battery cell group 112 may be the same in all the battery cell groups 112, or the number of the battery cells 111 may be different among the battery cell groups 112.

The battery cell management part 120 monitors the states of the battery cells 111 constituting the battery pack 110. The battery cell management part 120 includes a battery cell control part 121 provided for each of the battery cell groups 112. In FIG. 1, battery cell control parts 121a and 121b are provided correspondingly to the battery cell groups 112a and 112b. The battery cell control part 121 monitors and controls the states of the battery cells 111 constituting the battery cell group 112.

In the embodiment 1, for simplifying the explanation, the four battery cells 111 are electrically connected in series to constitute each of the battery cell groups 112a and 112b, and the battery cell groups 112a and 112b are further electrically connected in series. Thus, the battery pack 110 includes the eight battery cells 111 in total.

The battery pack control part 150 and the battery cell management part 120 transmit and receive signals through insulation elements 170 typified by a photocoupler and signal communication units 160.

A communication unit between the battery pack control part 150 and the battery cell control parts 121a and 121b constituting the battery cell management part 120 will be described. The battery cell control parts 121a and 121b are connected in series in ascending order of potential of the battery cell groups 112a and 112b respectively monitored by them. A signal transmitted from the battery pack control part 150 to the battery cell management part 120 is inputted to the battery cell control part 121a through the insulation element 170 and the signal communication unit 160. The output of the battery cell control part 121a is inputted to the battery cell control part 121b through the signal communication unit 160. The output of the lowest-level battery cell control part 121b is transmitted to the battery pack control part 150 through the insulation element 170 and the signal communication unit 160. In the embodiment 1, although the insulation element 170 does not intervene between the battery cell control part 121a and the battery cell control part 121b, the signal can also be transmitted and received through the insulation element 170.

The storage part 180 stores information such as internal resistance characteristics of the battery pack 110, the battery cells 111 and the battery cell groups 112, capacity at full charge, polarization voltage, deterioration characteristics, individual difference information, and correspondence relation between SOC and open circuit voltage. Incidentally, in this embodiment, although the storage part 180 is installed outside the battery pack control part 150 or the battery cell management part 120, the battery pack control part 150 or the battery cell management part 120 may include a storage part, and the information may be stored therein.

The battery pack control part 150 performs calculation of the SOC of at least one battery cell 111, state of health (SOH), and current and power capable of being inputted and outputted by using the information received from the battery cell management part 120, the current detection part 130, the voltage detection part 140 and the vehicle control part 200, and the information stored in the storage part 180. Various calculation results are transmitted to the battery cell management part 120 and the vehicle control part 200.

The vehicle control part 200 uses the information received from the battery pack control part 150, and controls the inverter 400 connected to the battery system 100 through the relays 300 and 310. Besides, the vehicle control part controls the charger 420 connected to the battery system 100 through the relays 320 and 330. During vehicle running, the battery system 100 is connected to the inverter 400, and drives a motor generator 410 by using the energy stored in the battery pack 110. At charging, the battery system 100 is connected to the charger 420, and is charged by power supply from a household power source or an electric station.

The charger 420 is used when the battery pack 110 is charged by using an external power source typified by the household or the electric station. In the embodiment 1, the charger 420 controls charge voltage and charge current based on the instruction from the battery pack control part 150 or the vehicle control part 200.

When a vehicle system mounted with the battery system 100 starts and runs, the battery system 100 is connected to the inverter 400 under management of the vehicle control part 200, and drives the motor generator 410 by using the energy stored in the battery pack 110. At the time of regeneration, the battery pack 110 is charged by power generated by the motor generator 410. When the vehicle provided with the battery system 100 is connected to the external power source typified by the household or the electric station, the battery system 100 and the charger 420 are connected to each other based on the information transmitted by the vehicle control part 200, and the battery pack 110 is charged until a specified condition is satisfied. The energy stored in the battery pack 110 by charging is used in the next vehicle running or can also be used for operating electrical components inside and outside the vehicle.

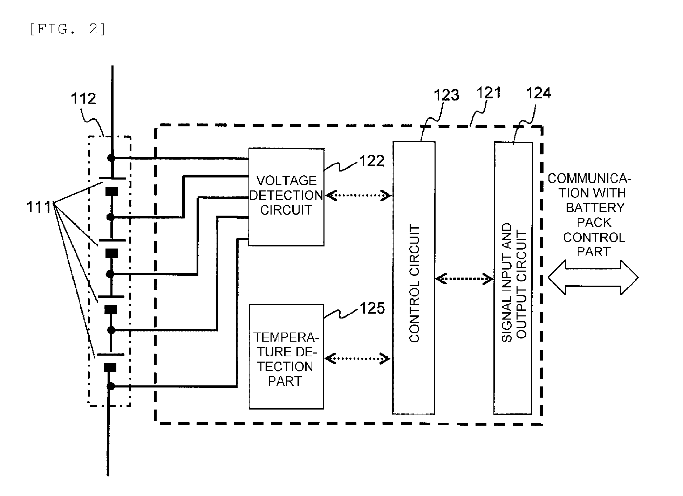

FIG. 2 is a view showing a circuit structure of the battery cell control part 121. The battery cell control part 121 includes a voltage detection circuit 122, a control circuit 123, a signal input and output circuit 124 and a temperature detection part 125. The voltage detection circuit 122 measures inter-terminal voltage of each of the battery cells 111. The temperature detection part 125 measures temperature of the battery cell group 112. The control circuit 123 receives the measurement results from the voltage detection circuit 122 and the temperature detection part 125, and transmits them to the battery pack control part 150 through the signal input and output circuit 124. Incidentally, since a circuit structure which is generally mounted on the battery cell control part 121 and uniforms voltage and SOC variation among the battery cells 111 generated by self-discharge or current consumption variation is well known, its description is omitted.

The temperature detection part 125 included in the battery cell control part 121 in FIG. 2 has a function to measure the temperature of the battery cell group 112. The temperature detection part 125 measures one temperature of the whole battery cell group 112, and treats the temperature as a temperature representative value of the battery cells 111 constituting the battery cell group 112. The temperature measured by the temperature detection part 125 is used for various calculations for detecting the state of the battery cell 111, the battery cell group 112 or the battery pack 110. Since this is a premise in FIG. 2, the one temperature detection part 125 is provided in the battery cell control part 121. The temperature detection part 125 is provided for each of the battery cells 111, the temperature is measured for each of the battery cells 111, and various calculations can be performed based on the temperature of each of the battery cells 111. However, in this case, the number of the temperature detection parts 125 increases, and the structure of the battery cell control part 121 becomes complicated.

FIG. 2 shows the temperature detection part 125 in a simple way. Actually, a temperature sensor is installed for a temperature measurement target, and the installed temperature sensor outputs temperature information as a voltage. This measurement result is transmitted to the signal input and output circuit 124 through the control circuit 123, and the signal input and output circuit 124 outputs the measurement result to the outside of the battery cell control part 121. The function to realize the series of flows is mounted as the temperature detection part 125 in the battery cell control part 121. The voltage detection circuit 122 can be used also for the measurement of the temperature information (voltage).

In the above, the structure of the battery system 100 is described. Next, a method in which the battery system 100 calculates the SOC of the battery cell 111 will be described.

<Embodiment 1: Method of calculating the state of charge>

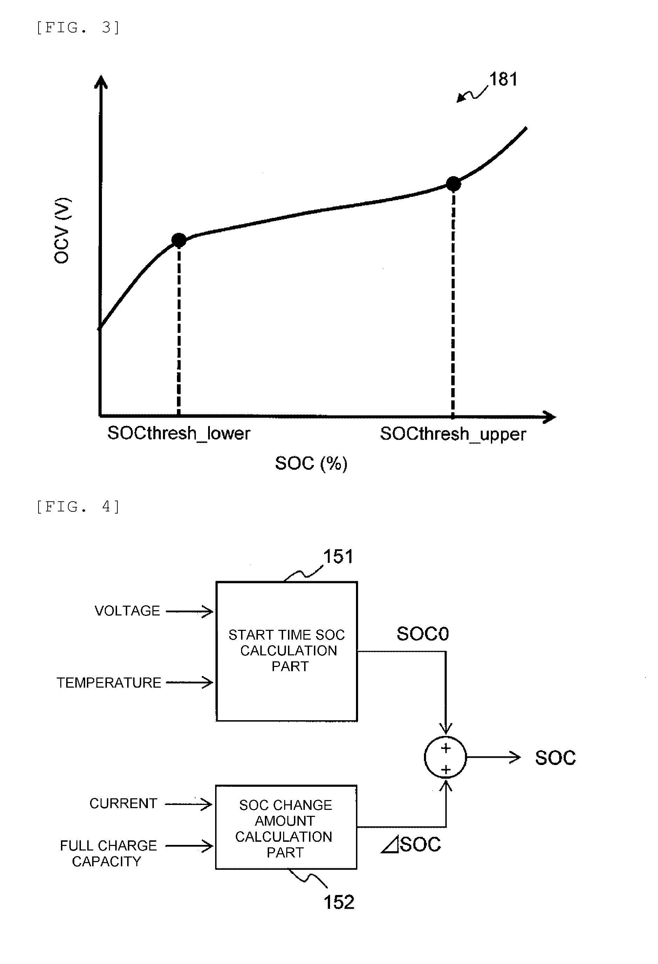

FIG. 3 is a view showing an example of an SOC table 181 stored in the storage part 180. The SOC table 181 is a data table describing a correspondence relation between the OCV of the battery cell 111 and the SOC of the battery cell 111. Although the data format may be arbitrary, for convenience of explanation, here, the data example is shown in graph format. Incidentally, although the data table is used in the description of the embodiment, the correspondence relation between the OCV and the SOC may be represented by a numerical expression or the like, and no limitation is made to the form of the data table. Besides, when the correspondence relation between the OCV and the SOC changes according to the temperature of the battery, the correspondence relation between the OCV and the SOC may be represented according to the temperature.

The OCV is the voltage of the battery cell 111 at the time of no load. The inter-terminal voltage of the battery cell 111, which is acquired at timing before the relays 300, 310, 320 and 330 are closed or in a state where charging and discharging of the battery pack 110 is not started although the relays 300, 310, 320 and 330 are closed, can be regarded as the OCV. Besides, although charging and discharging of the battery pack 110 is performed, if the current value is very low, the voltage of the battery cell 111 may be treated as the

OCV.

The battery pack control part 150 can obtain the SOC of the battery cell 111 by using the OCV of the battery cell 111 detected by the battery cell control part 121 and the SOC table 181. Besides, the SOC of the battery pack 110 can also be obtained by obtaining the total value of the OCVs of the battery cells 111. When the SOC characteristics are different among the respective battery cells 111, the SOC table 181 may be provided for each of the battery cells 111.

Here, SOC detection accuracy when the SOC table 181 is used will be studied. In order to calculate the SOC with high accuracy by using the OCV of the battery cell 111, it is desirable that the OCV significantly changes with respect to the change of the SOC. If the change of the OCV is small with respect to the change of the SOC, there is a possibility that quite a different SOC value is derived by a slight voltage detection error. In FIG. 3, a range of $SOC \geq SOC_{thresh\_upper}$ and a range of $SOC \leq SOC_{thresh\_lower}$ correspond to a high sensitivity range in which the OCV significantly changes with respect to the change of the SOC. Since the high sensitivity range varies according to the battery characteristic, it is required that a range corresponding to the high sensitivity range is previously grasped by an experiment or the like, and is recorded in the SOC table 181.

As described above, when the SOC corresponding to the OCV value is acquired, it is desirable that the SOC table 181 is used within the range of the high sensitivity range in which the OCV significantly changes with respect to the change of the SOC. Then, it is determined whether or not the OCV value acquired at the time of start of the battery system 100 (or the SOC value obtained from the SOC table 181) is within the high sensitivity range. If it is determined to be within the high sensitivity range, the SOC obtained from the SOC table 181 is adopted as the initial value of the SOC calculation. When the initial value of the SOC is once acquired, the SOC of the battery can be sequentially calculated by adding an SOC change amount calculated based on the integral value of battery current and the full charge capacity of the battery to the acquired SOC initial value.

On the other hand, if the OCV value is not within the range of the high sensitivity range, even if the SOC is acquired from the SOC table 181, there is a possibility that a large error is included in the SOC value due to a detection error of the OCV or the like. Then, in this case, the SOC table 181 is not used, and the previous SOC calculation result is adopted as the initial value. After this, the SOC of the battery can be sequentially calculated by adding an SOC change amount calculated based on the integral value of battery current and the full charge capacity of the battery to the acquired SOC initial value.

On the other hand, the previous SOC calculation result includes an error (accumulated error) accumulated by the current integrating process at the SOC calculation. If the case continues in which the OCV at the time of start of the battery system 100 is not within the high sensitivity range, the accumulated error continues to increase, and there is a fear that the error diverges. Then, in this embodiment, the SOC acquired from the SOC table 181 at the time of start of the battery system 100 is compared with the previous SOC calculation result, and if the gap is not smaller than a specified value, it is determined that the accumulated error included in the previous SOC calculation result is increasing, the SOC acquired from the SOC table 181 is adopted as the initial value of the SOC calculation, and the SOC is calculated.

As the foregoing specified value, for example, a value of an error which can occur in the SOC obtained from the SOC table 181 may be set. The error which can occur in the SOC obtained from the SOC table 181 can be obtained from the correspondence relation between the SOC and the OCV, and the voltage detection error. The foregoing SOC error may be obtained at the time of start of the battery system 100, or the previously obtained SOC error may be stored in the storage part 180.

FIG. 4 is a view represented in control block and showing the whole procedure in which the battery pack control part 150 calculates the SOC of the battery cell 111. The battery pack control part 150 includes a start time SOC calculation part 151 and an SOC change amount calculation part 152.

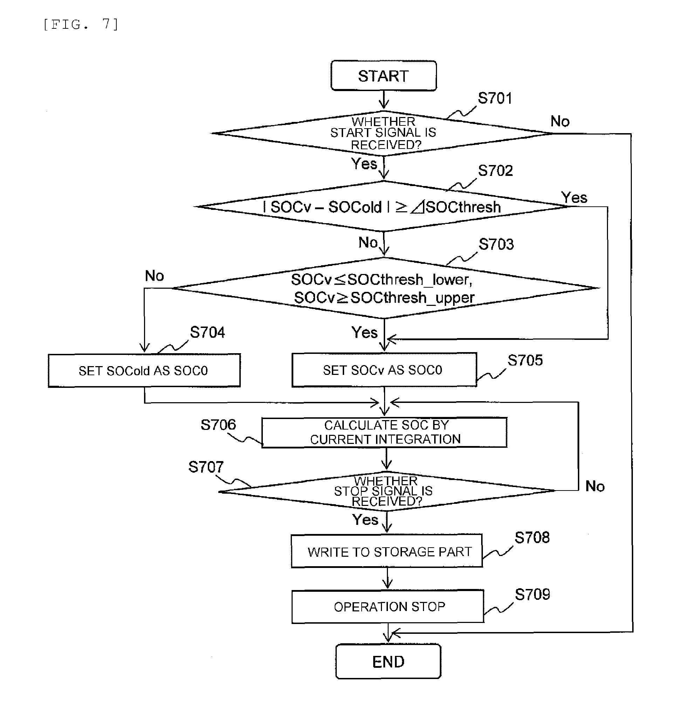

The start time SOC calculation part 151 receives, as an input, the open circuit voltage of the battery cell 111 and the temperature from the battery cell control part 121 and calculates the SOC initial calculation value SOC0 in accordance with an after-mentioned process flow described in FIG. 7. The SOC change amount calculation part 152 receives, as an input, the battery current flowing through the battery cell 111 and the full charge capacity of the battery cell 111, and calculates the change amount $\Delta$SOC of the SOC of the battery cell 111 based on the integral value of the battery current and the full charge capacity of the battery. As indicated by expression (1), the SOC at each time point can be calculated by sequentially adding the SOC change amount $\Delta$SOC to the initial value SOC0.

$$SOC = SOC0 + \Delta SOC ... \text{ expression (1)}$$

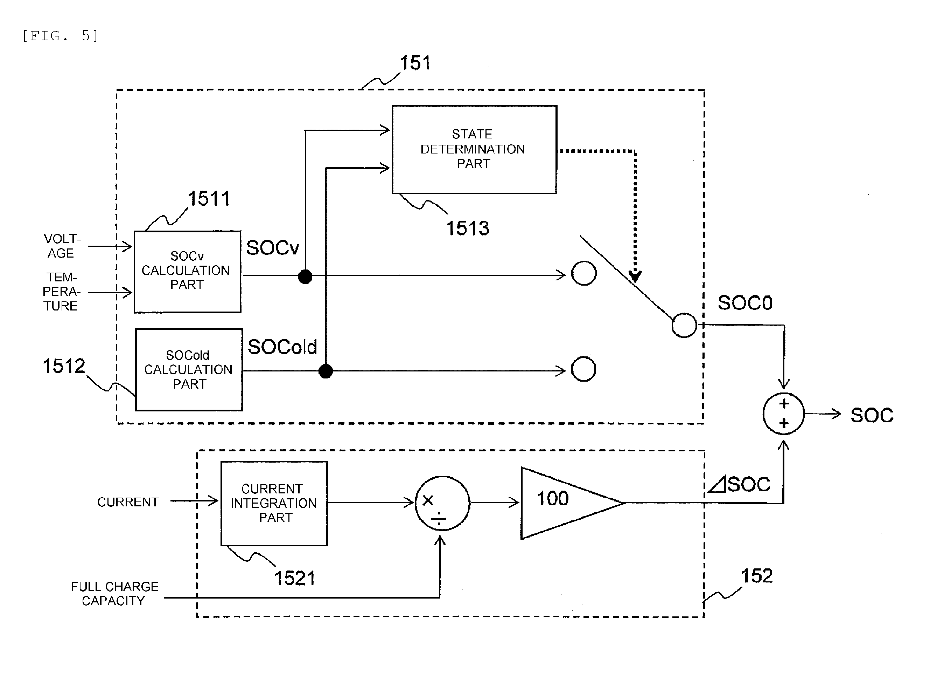

FIG. 5 is a view showing a detailed structure of the start time SOC calculation part 151 and the SOC change amount calculation part 152. In the following, the details of the respective parts will be described.

The start time SOC calculation part 151 includes an SOCv calculation part 1511, an SOCold calculation part 1512 and a state determination part 1513.

The SOCv calculation part 1511 receives the open circuit voltage of the battery cell 111 and the temperature as an input from the battery cell control part 121, and calculates the calculation value SOCv of the SOC by using the SOC table 181. The SOCold calculation part 1512 performs a suitable conversion process or the like on the previous SOC calculation value SOCold stored in the storage part 180 and outputs it. Here, the previous SOC calculation final value SOCold is a result obtained such that after the initial value SOC0 is once acquired in the past, the current is integrated and the subsequent SOC is calculated.

The state determination part 1513 determines which of the SOCv and the SOCold is adopted as the SOC0 in accordance with the after-mentioned process flow described in FIG. 7.

The SOC change amount calculation part 152 includes a current integration part 1521. The current integration part 1521 integrates the current of the battery cell 111. The SOC change amount calculation part 152 calculates the change amount $\Delta$SOC of the SOC from the calculation result of the current integration part 1521 and the full charge capacity of the battery cell 111 and in accordance with following expression (2).

$$\Delta SOC = 100 \times \int I dt / Qmax ... \text{ expression (2)}$$

Here, I denotes the current value [A] flowing through the battery, and Qmax denotes the full charge capacity [Ah] of the battery.

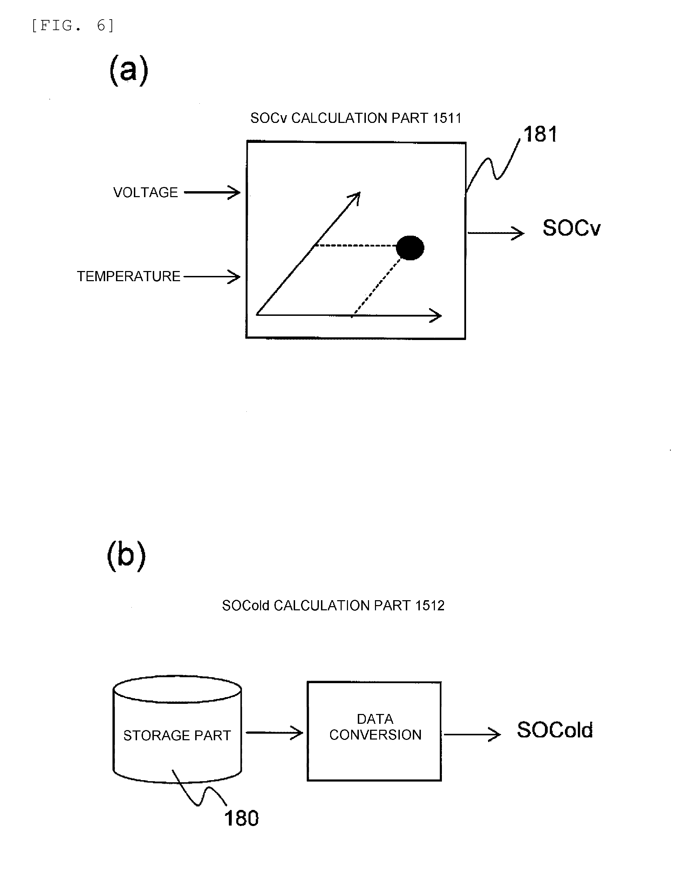

FIG. 6 is a view showing a detailed structure of the SOCv calculation part 1511 and the SOCold calculation part 1512. The SOCv calculation part 1511 receives the open circuit voltage of the battery cell 111 as the input from the battery cell control part 121, and acquires the corresponding SOC value from the SOC table 181. FIG. 3 shows only the correspondence relation between the OCV and the SOC for simplification of explanation. However, if the correspondence relation between the OCV and the SOC is changed by the temperature of the battery cell 111, a correspondence relation among the OCV, the temperature and the SOC is stored in the SOC table 181, and the SOC may be obtained by using these input values. The SOCold calculation part 1512 performs the suitable conversion process or the like on the previous SOC calculation value stored in the storage part 180.

<Embodiment 1: Operation Procedure of the System>

FIG. 7 is a flowchart for explaining an operation procedure in which the battery system 100 calculates the SOC of each of the battery cells 111. Hereinafter, respective steps of FIG. 7 will be described.

(FIG. 7: Step S701)

The battery pack control part 150 waits for a start signal for instructing start. When the start signal is received, the following steps are executed.

(FIG. 7: Step S702)

The start time SOC calculation part 151 acquires the SOCv and the SOCold described in FIG. 5 and FIG. 6 and obtains the absolute value of the difference therebetween. If the obtained absolute value of the difference is the specified error determination threshold $\Delta SOC_{thresh}$ or more, skip is made to step S705, and if smaller than $\Delta SOC_{thresh}$, advance is made to step S703.

(FIG. 7: Step S703)

The state determination part 1513 determines whether or not the SOC value acquired from the SOC table 181 is within the range of the high sensitivity range described in FIG. 3. In the example described in FIG. 3, if $SOCv \geq SOC_{thresh\_upper}$ or $SOCv \leq SOC_{thresh\_lower}$ is established, the SOCv is within the range of the high sensitivity range. If the SOCv is within the range of the high sensitivity range, advance is made to step S705, and if not, advance is made to step S704.

(FIG. 7: Step S704 to S705)

The state determination part 1513 adopts the SOCv as the initial value SOC0 if the SOCv is within the range of the high sensitivity range, and adopts the SOCold as the initial value SOC0 if not within the range of the high sensitivity range.

(FIG. 7: Step S706)

The SOC change amount calculation part 152 calculates the SOC change amount $\Delta SOC$ by integrating the current. The battery pack control part 150 calculates the SOC by using the initial value SOC0 and the SOC change amount $\Delta SOC$.

(FIG. 7: Step S707)

The battery pack control part 150 repeats step S706 until a stop signal for instructing stop is received. If the stop signal is received, advance is made to step S708.

(FIG. 7: Step S708 to S709)

The battery pack control part 150 writes the calculation value of the SOC obtained by the above steps to the storage part 180 (S708). This value is used as the SOCold when the battery pack control part 150 starts next time and calculates the SOC. The battery pack control part 150 writes the calculation result to the storage part 180, and then stops the operation (S709).

<Embodiment 1: Conclusion>

As described above, in the battery system 100 of the embodiment 1, when the SOC of the battery cell 111 is calculated, it is first determined whether or not the OCV and the SOC of the battery cell 111 is within the range of the high sensitivity range. If within the range, the initial value SOC0 is calculated by using the SOC table 181, and if not within the range, the previous calculation value is made the initial value SOC0. By this, the SOC calculation can be started by using the initial value SOC0 having higher calculation accuracy, and consequently, the calculation accuracy of the SOC can be increased.

Besides, if the SOCv and the SOCold significantly deviate from each other, the battery system 100 of the embodiment 1 determines that the error included in the SOCold is increasing, and does not adopt the SOCold even if the SOC is not within the high sensitivity range, but adopts the SOCv acquired from the SOC table 181 as the initial value SOC0. By this, since the effect of resetting the accumulated error of the SOC calculation due to the current integration is exerted, divergence of the accumulated error can be prevented.

<Embodiment 2>

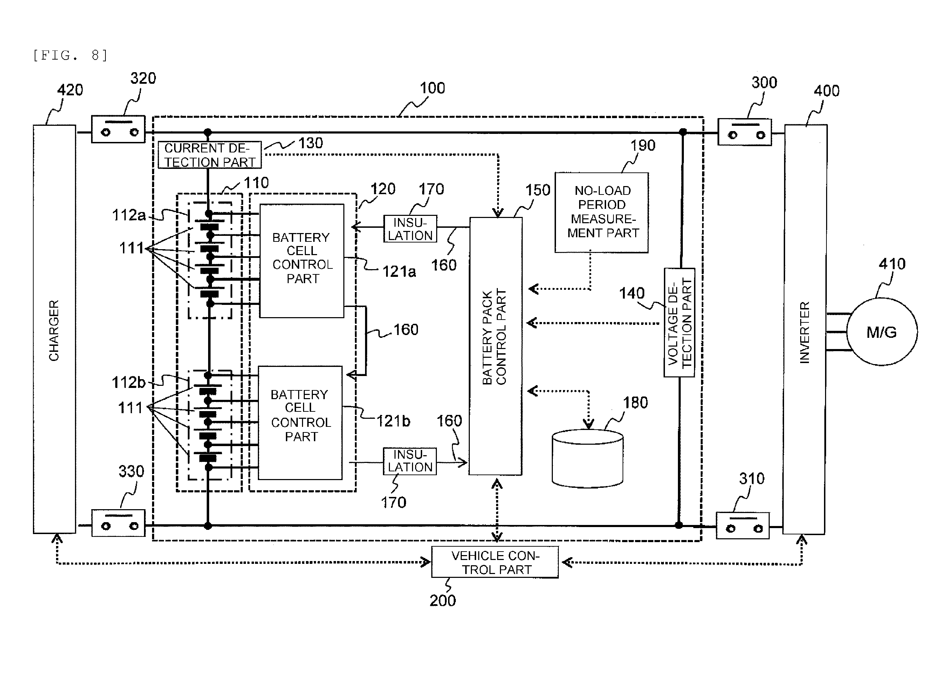

In embodiment 2 of the invention, a description will be made on a method of calculating the SOC in which a no-load period during which the battery cell 111 does not supply power is considered in the method described in the embodiment 1. FIG. 8 shows a structure of a battery system 100 in this embodiment. In this embodiment, a no-load period measurement part 190 to measure the no-load period during which the battery cell 111 does not supply power is added to the battery system 100 of the embodiment 1 shown in FIG. 1. Since the other structure is the same as the embodiment 1, a different point will be mainly described below.

A polarization phenomenon occurs when the battery cell 111 performs charging and discharging. When the polarization occurs, it becomes difficult to acquire an accurate value of battery voltage. Thus, it is desirable that the battery voltage is acquired after waiting during a sufficient time to resolve the polarization. In the embodiment 2, in view of this point, if the sufficient time to resolve the polarization passes, the SOC table 181 is used to calculate the initial value SOC0, and if not so, the previous SOC calculation value is made the initial value SOC0.

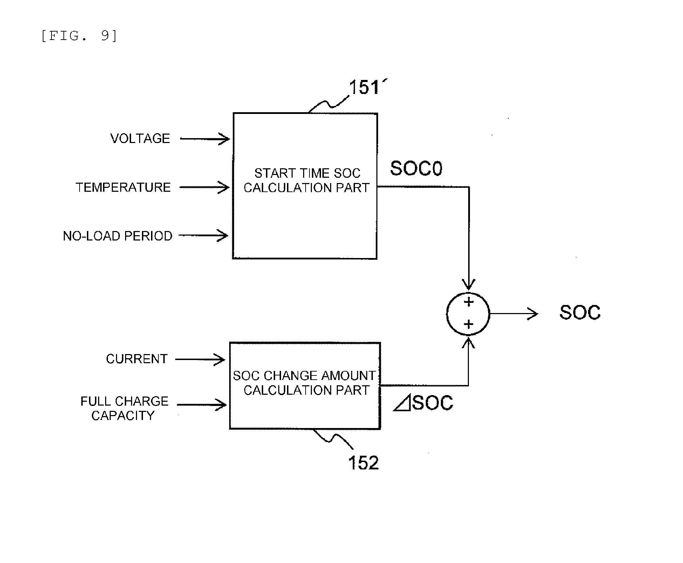

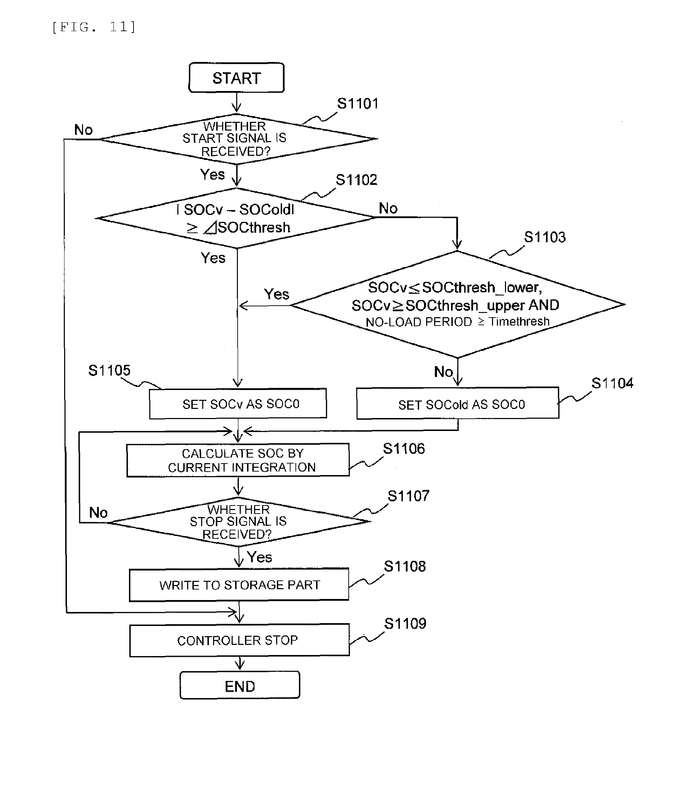

FIG. 9 is a view represented in control block and showing the whole procedure in which the battery pack control part 150 calculates the SOC of the battery cell 111 in the embodiment 2. In the embodiment 2, a start time SOC calculation part 151' receives, as an input, a no-load period outputted from the no-load period measurement part 190 such as a timer in addition to the open circuit voltage of the battery cell 111 and the temperature, and calculates the initial value SOC0 of the SOC in accordance with an after-mentioned process flow described in FIG. 11. Incidentally, in this embodiment, as shown in FIG. 8, the no-load period measurement part 190 to measure the no-load period is installed outside the battery pack control part 150 or the battery cell management part 120. However, the battery pack control part 150 or the battery cell management part 120 may include the no-load period measurement part 190.

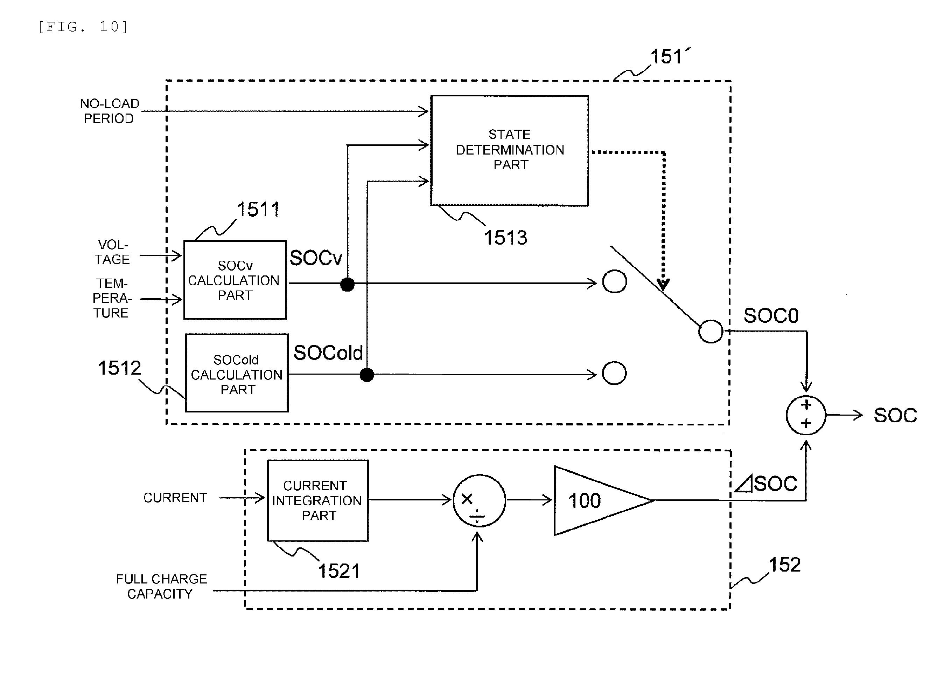

FIG. 10 is a view showing a detailed structure of an SOCv calculation part 1511 and an SOCold calculation part 1512 in the embodiment 2. A state determination part 1513 receives the no-load period of the battery cell 111, and determines which of the SOCv and the SOCold is adopted as the initial value SOC0 in accordance with the after-mentioned process flow described in FIG. 11.

FIG. 11 is a flowchart for explaining an operation procedure in which the battery system 100 calculates the SOC of each of the battery cells 111. Hereinafter, respective steps of FIG. 11 will be described.

(FIG. 11: Step S1101 to S1102, S1104 to S1109)

These steps are the same as steps S701 to S702, and S704 to S709 of FIG. 7.

(FIG. 11: Step S1103)

The state determination part 1513 determines whether or not the SOC value acquired from the SOC table 181 is within the range of the high sensitivity range described in FIG. 3. Further, it is determined whether or not the no-load period of the battery cell 111 is a specified polarization determination threshold $Time_{thresh}$ or more. If both the conditions are satisfied, advance is made to step S1105, and if at least one of them is not satisfied, advance is made to step S1104.

<Embodiment 2: Conclusion>

As described above, in the battery system 100 of the embodiment 2, if the sufficient no-load period (= polarization determination threshold $Time_{thresh}$) passes during which the polarization is supposed to be resolved, and the OCV of the battery cell 111 is within the high sensitivity range, the SOC table 181 is used, and the initial value SOC0 is calculated. If not so, the previous SOC calculation value stored in the storage part 180 is made the initial value SOC0. By this, the influence of the polarization is avoided, and the SOC can be calculated with high accuracy.

<Embodiment 3>

In the embodiments 1 and 2, if the previous SOC calculation result can not be acquired from the storage part 180, the SOCold can not be used as the initial value SOC0. As an example in which the SOCold can not be obtained, a case in which the previous calculation result is not stored in the storage part 180 because immediately after factory shipment, or a case in which an error occurs in the stored value can be mentioned.

8

Then, in embodiment 3 of the invention, if the previous calculation result SOCold can not be acquired, the SOC is acquired from the SOC table 181 irrespective of whether or not the other conditions are established. Since a structure of a battery system 100 is the same as the embodiments 1 and 2, a different point will be mainly described below. Incidentally, in the following description, although an example is adopted in which the above method is added to the operation example described in the embodiment 2, the same method can be applied also to the embodiment 1.

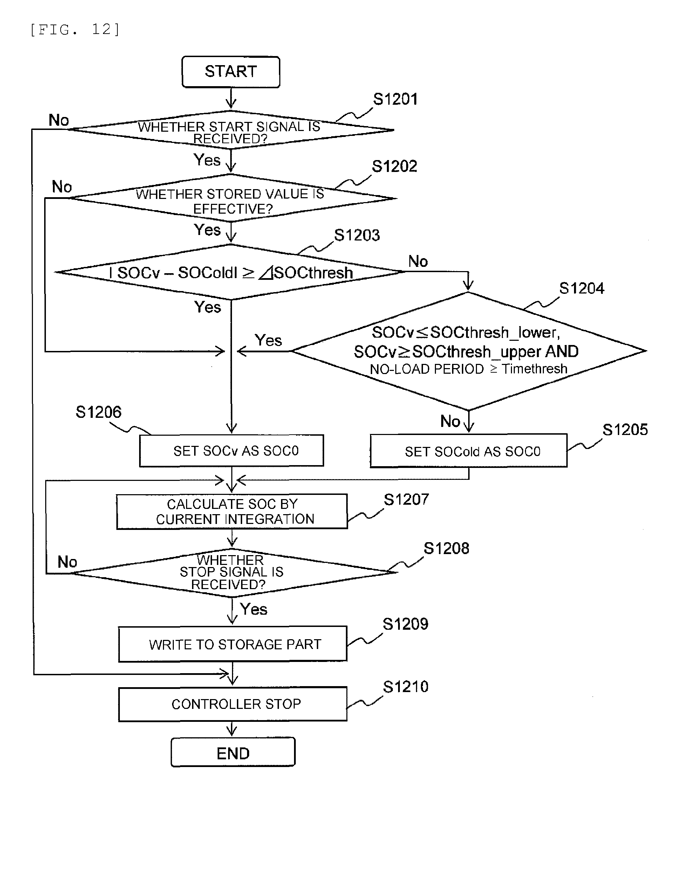

FIG. 12 is a flowchart for explaining an operation procedure in which the battery system 100 calculates the SOC of each of battery cells 111 in the embodiment 3. Hereinafter, respective steps of FIG. 12 will be described.

(FIG. 12: Step S1201)

This step is the same as step S1201 of FIG. 10. However, after the battery pack control part 150 receives a start signal at this step, advance is made to step S1202 newly provided in the embodiment 3.

(FIG. 12: Step S1202)

The battery pack control part 150 determines whether or not an effective previous calculation value SOCold is stored in the storage part 180. As an example in which the SOCold stored in the storage part 180 is ineffective, there can be mentioned a case where the previous SOC calculation value SOCold is not stored in the storage part 180 because immediately after factory shipment, a case where it is detected that the battery pack 110 is exchanged, and a case where the storage part 180 is damaged. In ineffective, skip is made to step S1206, and if effective, advance is made to step S1203.

(FIG. 12: Step S1203 to S1210)

These steps are the same as steps S1102 to S1109 of FIG. 11.

<Embodiment 3: Conclusion>

As described above, the battery system 100 of the embodiment 3 calculates the initial value SOC0 by using the SOC table 181 if the effective previous calculation value SOCold is not stored in the storage part 180, and uses the same method as the embodiments 1 and 2 if the effective value is stored. By this, also at the time of factory shipment or at the time of occurrence of memory error, the SOC calculation can be appropriately performed.

In the above, although the invention made by the inventor is specifically described based on the embodiments, it is needless to say that the invention is not limited to the foregoing embodiments, and various modifications can be made in the range not departing from the gist.

Besides, the above respective structures, functions and processing parts can be realized as hardware by designing all or part thereof with, for example, an integrated circuit, or can also be realized as software by a program which realizes the respective functions and is executed by a processor. The program for realizing the respective functions and the information such as the table can be stored in a storage device such as a memory or a hard disk or a storage medium such as an IC card or a DVD.

Reference Signs List

100: battery system, 110 : battery pack, 111 : battery cell, 112: battery cell group, 120: battery cell management part, 121: battery cell control part, 122 : voltage detection circuit, 123: control circuit, 124: signal input and output circuit, 125: temperature detection part, 130: current detection part, 140: voltage detection part, 150: battery pack control part, 151: start time SOC calculation part (embodiment 1), 151': start time SOC calculation part (embodiment 2), 1511: SOCv calculation part, 1512: SOCold calculation part, 1513: state determination part, 152: SOC change amount calculation part, 1521: current integration part, 160: signal communication unit, 170: insulation element, 180: storage part, 181: SOC table, 200: vehicle control part, 190: no-load period measurement part, 300 to 330: relay, 400: inverter, 410: motor generator, 420: charger

**Claims**

1. A battery control apparatus comprising:

a control part to control a battery pack in which a plurality of battery cells are connected;
a voltage measurement part to measure an inter-terminal voltage of the battery cell or the battery pack;

a current measurement part to measure a current of the battery cell or the battery pack; and

a storage part to store battery characteristic information indicating a correspondence relation between an open circuit voltage of the battery cell and a state of charge, wherein

the control part

determines whether or not the open circuit voltage of the battery cell is within a high sensitivity range in which the open voltage of the battery cell changes by a specified amount or more with respect to a change in the state of charge of the battery cell in the correspondence relation stored in the storage part,

if the open circuit voltage of the battery cell is within the high sensitivity range,

the control part adopts, as an initial value, the state of charge of the battery cell acquired by using the inter-terminal voltage measured by the voltage measurement part and the battery characteristic information, and then, integrates the current measured by the current measurement part to calculate a change amount in the state of charge of the battery cell, calculates the state of charge of the battery cell by using the calculation value and the battery characteristics information, and stores the calculation result in the storage part, and

if the open circuit voltage of the battery cell is not within the high sensitivity range,

the control part adopts, as an initial value, the state of charge stored in the storage part, and then, integrates the current measured by the current measurement part to calculate the change amount in the state of charge of the battery cell, and calculates the state of charge of the battery cell by using the calculation value and the state of charge stored in the storage part.

2. The battery control apparatus according to claim 1, wherein

the control part

calculates a difference between the state of charge of the battery cell acquired by using the inter-terminal voltage measured by the voltage measurement part and the battery characteristic information and the state of charge stored in the storage part, and

adopts, as the initial value, the state of charge of the battery cell acquired by using the inter-terminal voltage measured by the voltage measurement part and the battery characteristic if the difference is an error determination threshold or more.

3. The battery control apparatus according to claim 1, wherein

the control part adopts, as the initial value, the state of charge of the battery cell acquired by using the inter-terminal voltage measured by the voltage measurement part and the battery characteristic information if the state of charge stored in the storage part is ineffective.

4. The battery control apparatus according to claim 1, wherein

the control part adopts, as the initial value, the state of charge of the battery cell acquired by using the inter-terminal voltage measured by the voltage measurement part and the battery characteristic information if the open circuit voltage of the battery cell is within the high sensitivity range, and a period in which the battery cell and the battery pack do not supply power is a specified threshold or more, and

adopts, as the initial value, the state of charge stored in the storage part if the open circuit voltage of the battery cell is not within the high sensitivity range or the period in which the battery cell and the battery pack do not supply power is less than the threshold.

5. A battery system comprising:

a battery control apparatus according to claim 1; and

a battery pack in which a plurality of battery cells are connected, wherein

the battery control apparatus controls the battery cells and the battery pack.

[FIG. 1]

[FIG. 2]

[FIG. 3]

[FIG. 4]

[FIG. 5]

[FIG. 6]

## (a)

SOCv CALCULATION PART 1511

VOLTAGE ⟶

TEMPERATURE ⟶

181

⟶ SOCv

## (b)

SOCold CALCULATION PART 1512

STORAGE PART ⟶ DATA CONVERSION ⟶ SOCold

180

[FIG. 7]

```
                        ┌──────────────┐
                        │    START     │
                        └──────┬───────┘
                               │                    S701
                               ▼
                      ╱─────────────────╲                        No
              ╱────────  WHETHER           ────────────────────────┐
              ╲─────────  START SIGNAL IS  ───────╱                 │
                      ╲   RECEIVED?      ╱                          │
                        ╲───────────────╱                          │
                          Yes │                                    │
                              │              S702                  │
                              ▼                                    │
                      ╱─────────────────────────╲      Yes         │
              ╱────────  | SOCv – SOCold | ≥ △SOCthresh ───────┐   │
              ╲─────────                          ───────╱      │   │
                      ╲───────────────────────╱                │   │
                          No │        S703                     │   │
                             ▼                                 │   │
         No      ╱─────────────────────────────╲              │   │
      ┌──────────  SOCv ≤ SOCthresh_lower,       ────────╲     │   │
      │          ╲  SOCv ≥ SOCthresh_upper      ───────╱       │   │
      │           ╲─────────────────────────────╱             │   │
      │    S704          Yes │ ◄───────────────────────────────   │
      │                      │                                     │
      ▼                      ▼                S705                 │
┌──────────────┐      ┌──────────────────────┐                    │
│ SET SOCold   │      │  SET SOCv AS SOC0     │                    │
│ AS SOC0      │      └──────────┬───────────┘                    │
└──────┬───────┘                 │                                │
       │        ┌────────────────┤◄──────────────────┐            │
       └───────►▼                ▼                    │            │
         S706  ┌──────────────────────────┐          │            │
              │   CALCULATE SOC BY         │          │            │
              │   CURRENT INTEGRATION      │          │            │
              └──────────┬───────────────┘           │            │
         S707            ▼                             │            │
              ╱────────────────────╲        No        │            │
        ┌──────  WHETHER             ───────────────────            │
        ╲─────   STOP SIGNAL IS    ───────╱                         │
              ╲  RECEIVED?        ╱                                 │
                ╲───────────────╱                                  │
                  Yes │                     S708                    │
                      ▼                                             │
              ┌──────────────────────┐                             │
              │  WRITE TO STORAGE PART│                             │
              └──────────┬───────────┘                             │
                         ▼            S709                          │
              ┌──────────────────────┐                             │
              │   OPERATION STOP      │                             │
              └──────────┬───────────┘                             │
                         ▼ ◄──────────────────────────────────────┘
                  ┌──────────────┐
                  │     END      │
                  └──────────────┘
```

[FIG. 8]

[FIG. 9]

[FIG. 10]

EP 2 720 054 A1

[FIG. 11]

```
                    ┌─────────────┐
                    │   START     │
                    └──────┬──────┘
                           │                    S1101
        No         ◇───────┴────────◇
    ┌──────────────   WHETHER
    │               START SIGNAL IS
    │                 RECEIVED?
    │              ◇────────────────◇
    │                    Yes │              S1102
    │              ◇──────────┴──────────◇        No
    │              │ I SOCv − SOCold I   │──────────────┐
    │              │    ≥ △SOCthresh     │              │
    │              ◇──────────┬──────────◇              │        S1103
    │                    Yes │                          ▼
    │                        │         Yes    ◇──────────────────◇
    │                        │   ┌────────────  SOCv≤SOCthresh_lower,
    │                        │   │            SOCv≥SOCthresh_upper AND
    │                        │   │            NO-LOAD PERIOD ≥ Timethresh
    │                        │   │            ◇─────────┬────────◇
    │ S1105                  │   │                   No │
    │ ┌─────────────────┐    │   │            ┌─────────▼─────────┐  S1104
    │ │ SET SOCv AS SOC0│◀───┘   └───────────▶│ SET SOCold AS SOC0│
    │ └────────┬────────┘                     └─────────┬─────────┘
    │          │         ┌────────────────────────────┐ │
    │          └────────▶│  CALCULATE SOC BY          │◀┘
    │                    │  CURRENT INTEGRATION       │  S1106
    │                    └────────────┬───────────────┘
    │                         ◇───────┴────────◇   S1107
    │        No               │   WHETHER      │
    │  ┌──────────────────────  STOP SIGNAL IS
    │  │                      │   RECEIVED?    │
    │  │                      ◇───────┬────────◇
    │  │                          Yes │           S1108
    │  │                    ┌─────────▼─────────┐
    │  │                    │ WRITE TO STORAGE PART │
    │  │                    └─────────┬─────────┘
    │  │                              │           S1109
    │  │                    ┌─────────▼─────────┐
    └──┴───────────────────▶│  CONTROLLER STOP  │
                           └─────────┬─────────┘
                           ┌─────────▼─────────┐
                           │       END         │
                           └───────────────────┘
```

[FIG. 12]

```
                    ┌─────────┐
                    │  START  │
                    └─────────┘
                         │
                         ▼                        S1201
     No    ╱────────────────────────────╲
    ◄──────  WHETHER START SIGNAL IS
           ╲      RECEIVED?             ╱
                      │
                    Yes │                           S1202
     No    ╱────────────────────────────╲
    ┌──────  WHETHER STORED VALUE IS
    │      ╲      EFFECTIVE?            ╱
    │                 │
    │               Yes │                    S1203
    │      ╱──────────────────────────╲      No
    │   ◄── │SOCv – SOCold│ ≥ ⧌SOCthresh ╲──────────┐
    │      ╲──────────────────────────╱              │
    │                 │                              ▼
    │               Yes │                                          S1204
    │                 │        Yes    ╱────────────────────────────────╲
    │                 │      ◄─────── SOCv≤SOCthresh_lower,
    │                 │               SOCv≥SOCthresh_upper AND        ╱
    │                 │               ╲ NO-LOAD PERIOD ≥ Timethresh  ╱
    │                 │                           │
    │  S1206          │                         No │              S1205
    │  ┌──────────────▼──────┐        ┌───────────────────────┐
    │  │  SET SOCv AS SOC0   │        │  SET SOCold AS SOC0   │
    │  └─────────────────────┘        └───────────────────────┘
    │                 │                           │
    │                 ▼◄──────────────────────────┘
    │      ┌──────────────────────┐               S1207
    │      │  CALCULATE SOC BY    │
    │      │  CURRENT INTEGRATION │
    │      └──────────────────────┘
    │                 │
    │                 ▼                            S1208
    │   No  ╱──────────────────────╲
    └─────── WHETHER
            STOP SIGNAL IS
           ╲   RECEIVED?          ╱
                      │
                    Yes │                          S1209
            ┌──────────────────────┐
            │  WRITE TO STORAGE PART │
            └──────────────────────┘
                      │
                      ▼                            S1210
            ┌──────────────────────┐
            │   CONTROLLER STOP    │
            └──────────────────────┘
                      │
                      ▼
                 ┌─────────┐
                 │   END   │
                 └─────────┘
```

## INTERNATIONAL SEARCH REPORT

| International application No. |
| --- |
| PCT/JP2011/063356 |

A. CLASSIFICATION OF SUBJECT MATTER
*G01R31/36*(2006.01)i

According to International Patent Classification (IPC) or to both national classification and IPC

B. FIELDS SEARCHED

Minimum documentation searched (classification system followed by classification symbols)
G01R31/36

Documentation searched other than minimum documentation to the extent that such documents are included in the fields searched
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 2003-149307 A (Toyota Motor Corp.), 21 May 2003 (21.05.2003), entire text; all drawings & US 2003/0097225 A1 | 1-5 |
| Y | JP 2010-88194 A (Nissan Motor Co., Ltd.), 15 April 2010 (15.04.2010), entire text; all drawings (Family: none) | 1-5 |
| Y | JP 2007-192726 A (Nissan Motor Co., Ltd.), 02 August 2007 (02.08.2007), entire text; all drawings (Family: none) | 1-5 |

☒ Further documents are listed in the continuation of Box C.  ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 31 August, 2011 (31.08.11) | 13 September, 2011 (13.09.11) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**INTERNATIONAL SEARCH REPORT**

International application No.

PCT/JP2011/063356

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2000-166109 A (Toyota Motor Corp.), 16 June 2000 (16.06.2000), entire text; all drawings (Family: none) | 2 |
| Y | JP 2008-145349 A (The Furukawa Electric Co., Ltd.), 26 June 2008 (26.06.2008), entire text; all drawings (Family: none) | 3-4 |

Form PCT/ISA/210 (continuation of second sheet) (July 2009)

**EP 2 720 054 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008064496 A